# EUROPÄISCHE PATENTSCHRIFT

(11) **EP 3 477 315 B1**
(45) Veröffentlichungstag und Bekanntmachung des Hinweises auf die Patenterteilung: **14.10.2020**
(21) Anmeldenummer: 18202026.3
(22) Anmeldetag: 23.10.2018
(51) Int. Cl.: G01R 31/00, G01R 31/28, G06F 7/42, H01R 13/74

(54) **MECHANISMUS**
MECHANISM
MECHANISME

(30) Priorität: 25.10.2017 DE 102017124949
(43) Veröffentlichungstag der Anmeldung: 01.05.2019
(73) Patentinhaber: ODU GmbH & Co. KG, 84453 Mühldorf (DE)
(72) Erfinder: Weichselgartner, Dominik, 84137 Vilsbiburg (DE)
(74) Vertreter: SR Huebner - Munich Patentanwaltspartnerschaft mbB

(56) Entgegenhaltungen:
- NL-A- 6 611 891
- US-A1- 2001 023 774
- US-A1- 2001 054 891
- US-A1- 2002 137 389
- US-A1- 2013 045 625

## Beschreibung

### Gebiet der Erfindung

Die Erfindung betrifft einen Mechanismus zum Fixieren eines in einen Modulaufnahmerahmen eingesetzten Moduls an dem Modulaufnahmerahmen und Lösen des Moduls zur Entnahme aus dem Modulaufnahmerahmen. Die Erfindung betrifft weiterhin einen Modulaufnahmerahmen mit dem Mechanismus. Sie betrifft auch ein Modul mit dem Mechanismus. Darüber hinaus betrifft die Erfindung ein System bestehend aus dem Mechanismus, einem Modul und einem Modulaufnahmerahmen. Schließlich betrifft die Erfindung auch einen Receiver oder einen Interchangeable-Test-Adapter für einen Mass-Interconnect, wobei der Receiver oder der Interchangeable-Test-Adapter den Modulaufnahmerahmen oder das System aufweist.

### Hintergrund der Erfindung

Aus dem US-Patent US 4,655,530 A ist ein Snap-in-Modul für den Rahmen eines Receivers oder eines Testadapters bekannt, das mittels eines Stößels, der durch eine Feder vorgespannt ist, fixiert wird. Eine Anlaufschräge am Stößel sorgt dafür, dass das Modul beim Einsetzen selbsttätig einrastet. Zum Entnehmen des Moduls wird der Stößel mit einem an ein Gewinde des Stößels anschraubbaren Werkzeug bewegt, um das Modul vom Rahmen zu lösen.

Das US-Patent US 3,040,289 A beschreibt eine ähnliche Lösung, bei der die Module durch einen Stößel fixiert werden, der mit einer Feder vorgespannt ist, wobei sich die Stößel-Feder-Kombination diesmal nicht am Modul, sondern am Receiverrahmen befindet. Eine Anlaufschräge am Modul stellt sicher, dass das Modul beim Einsetzen selbsttätig einrastet. Zum Entfernen des Moduls muss der Stößel mittels eines Griffs gegen die Federkraft zurückbewegt werden.

Aus dem US-Patent US 6,547,587 B2 ist ein Modul mit einem festen Nocken und einen federgespannten Stößel bekannt. Zum Einsetzen in einen Receiverrahmen wird das Modul von hinten in den Receiverrahmen montiert, wobei es zunächst mit dem Nocken in eine korrespondierende Vertiefung einer Schiene auf der Unterseite des Receiverrahmens gesetzt, dann nach vorne gekippt und anschließend nach oben geschoben wird, um auch dort in eine Schiene einzugreifen. Dabei wird der Stößel zunächst von einer vorderen Flanke der oberen Schiene gegen die Federkraft zurückgeschoben und, sobald er durch die Nach-Oben-Bewegung des Moduls ein Loch erreicht hat, durch die Feder in das Loch bewegt, um das Modul zu fixieren. Zum Entfernen des Moduls muss der Stößel mittels eines Werkzeugs zurückbewegt werden.

In dem US-Patent US 5,562,458 A wird vorgeschlagen, die Module mit konventionellen Bolzen oder Schrauben an dem Rahmen zu befestigen. Ähnlich dazu verweist das US-Patent US 4,329,005 A lediglich auf Schrauben, die in Vertiefungen eingreifen sollen.

Die US Patentanmeldung US 2001/0054891 A1 beschreibt einen Transportarm für Trays, eine Testvorrichtung für elektronische Komponenten und ein Verfahren zum Transportieren von Trays. Der Transportarm kann unabhängig von der Art der Kundentrays in weiten Bereichen eingesetzt werden und ist in der Lage, die Stabilität beim Haltern der zu testenden ICs aufrecht zu erhalten. Der Transportarm zum Transportieren der Trays von Kunden, die mit einer Vielzahl von zu testenden ICs beladen sind, umfasst eine Abdeckplatte zum Abdecken der Öffnungsfläche einer Ausnehmung des Trays. Der Transportarm umfasst eine Mehrzahl von rotierbaren Riegelelementen, die in eine geöffnete und in eine geschlossene Stellung rotierbar sind und in der geschlossenen Stellung das Tray des Kunden haltern.

### Der Erfindung zugrundeliegende Idee

Der Erfindung liegt die Aufgabe zugrunde, einen verbesserten Mechanismus zum Fixieren eines in einen Modulaufnahmerahmen eingesetzten Moduls an dem Modulaufnahmerahmen und Lösen des Moduls zur Entnahme aus dem Modulaufnahmerahmen bereitzustellen. Der Erfindung liegt weiterhin die Aufgabe zugrunde, einen verbesserten Modulaufnahmerahmen mit dem Mechanismus bereitzustellen. Der Erfindung liegt außerdem die Aufgabe zugrunde, ein verbessertes Modul mit dem Mechanismus bereitzustellen. Darüber hinaus liegt der Erfindung die Aufgabe zugrunde, ein verbessertes System bestehend aus dem Mechanismus, einem Modul und einem Modulaufnahmerahmen bereitzustellen. Schließlich liegt der Erfindung die Aufgabe zugrunde, einen verbesserten Receiver oder einen verbesserten Interchangeable-Test-Adapter für einen Mass-Interconnect bereitzustellen, wobei der Receiver oder der Interchangeable-Test-Adapter den Modulaufnahmerahmen oder das System aufweist.

### Erfindungsgemäße Lösung

Die Bezugszeichen in sämtlichen Ansprüchen haben keine einschränkende Wirkung, sondern sollen lediglich deren Lesbarkeit verbessern.

Die Lösung der gestellten Aufgabe gelingt durch einen Mechanismus zum Fixieren eines in einem Modulaufnahmerahmen eingesetzten Moduls an dem Modulaufnahmerahmen und Lösen des Moduls zur Entnahme aus dem Modulaufnahmerahmen. Der erfindungsgemäße Mechanismus weist einen an dem Modul oder dem Modulaufnahmerahmen angeordneten Riegel auf, der zwischen einer Offenstellung und einer Sperrstellung hin- und herbewegt werden kann. Außerdem ist eine Feder vorgesehen. Weiter weist der Mechanismus einen Riegelhalter auf, der zwischen einer Haltestellung, in der er den Riegel gegen die Vorspannung der Feder zurückhält, und einer Lösestellung, in der er den Riegel nicht entgegen der Vorspannung der Feder zurückhält, hin- und herbewegt werden kann und so ausgebildet und angeordnet ist, dass sowohl die Haltestellung als auch die Lösestellung eine Ruhestellung des Riegelhalters ist. Die Feder ist dazu vorgesehen, um den Riegel in eine der beiden Stellungen Offenstellung oder Sperrstellung vorzuspannen. Der Riegelhalter ist so ausgebildet und in dem Mechanismus so angeordnet, dass eine Bewegung des Riegelhalters von der Haltestellung in die Lösestellung den Riegel freigibt, so dass der Riegel sich durch die Kraft der Feder von seiner Sperrstellung in seine Offenstellung oder von seiner Offenstellung in seine Sperrstellung bewegt.

Im Sinne der Erfindung bedeutet "Fixieren", dass das Modul nach dem Fixieren nicht mehr ohne Betätigen des Mechanismus aus dem Modulaufnahmerahmen entfernt werden kann. Die "Sperrstellung" bezeichnet im Sinne der vorliegenden Erfindung die Stellung des Riegels, in der das Modul durch den Riegel in dem Modulrahmen fixiert ist. Hingegen bezeichnet die "Offenstellung" im Sinne der vorliegenden Erfindung die Stellung des Riegels, in der das Modul nicht durch den Riegel in dem Modulrahmen fixiert ist.

Der "Modulaufnahmerahmen" im Sinne der vorliegenden Erfindung ist ein Rahmen, in dessen Innenbereich ein oder mehrere Module einsetzbar und daran fixierbar sowie davon lösbar und aus dem Innenbereich entnehmbar sind. Der Modulaufnahmerahmen muss nicht notwendigerweise geschlossen sein sondern kann auch eine oder mehrere offene Seiten oder Abschnitte aufweisen.

Im Sinne der vorliegenden Erfindung sind die Haltestellung und die Lösestellung dann jeweils eine "Ruhestellung", wenn der Riegelhalter sich aufgrund seiner Ausbildung und Anordnung in den Mechanismus in dem Fall, dass der Mechanismus nicht von außen betätigt wird, von der Haltestellung bzw. der Lösestellung nicht mehr in die andere der beiden Stellungen, also die Lösestellung bzw. die Haltestellung, bewegt.

Dadurch, dass der Riegelhalter eine Lösestellung und eine Haltestellung hat, kann vorteilhafterweise erreicht werden, dass der Riegel in der Offenstellung, je nach Ausführungsform, festliegen oder festgelegt werden kann, sodass das Modul von einem Benutzer bequem in den Modulaufnahmerahmen eingesetzt werden kann. Insbesondere kann vermieden werden, dass der Benutzer, um das Modul in den Modulaufnahmerahmen einsetzen zu können, ständig den Riegel gegen die Kraft der Feder betätigen muss, um ihn in der Offenstellung zu halten. Außerdem ist mit der Erfindung vorteilhafterweise erreichbar, dass der Benutzer durch Bewegen des Riegelhalters, je nach Ausführungsform, von der Haltestellung in die Lösestellung oder von der Lösestellung in die Haltestellung ein Bewegen des Riegels von der Offenstellung in die Sperrstellung zulassen (wobei die Bewegung vorzugsweise durch die Feder bewirkt wird) bzw. bewirken (vorzugsweise gegen die Kraft der Feder) kann, um das Modul in dem Modulaufnahmerahmen zu fixieren.

Die Lösung der Erfindungsaufgabe gelingt außerdem durch einen Modulaufnahmerahmen mit dem oben beschriebenen Mechanismus. Dabei kann vorteilhafterweise ausgenutzt werden, dass der Modulaufnahmerahmen in der Regel mehr Bauraum für den Mechanismus bietet als das Modul. Außerdem kann es in Situationen, wo eine Anzahl von alternativ zueinander verwendbaren Modulen wesentlich größer ist als die Anzahl der für Module in dem Rahmen zur Verfügung stehenden Plätze, sparsamer sein, den Mechanismus an dem Modulaufnahmerahmen vorzusehen.

Die Erfindungsaufgabe wird jedoch auch durch ein Modul mit dem oben beschriebenen Mechanismus gelöst. Den Mechanismus an dem Modul vorzusehen, kann insbesondere dann von Nutzen sein, wenn in dem Modulaufnahmerahmen Module unterschiedlicher Dimensionen, insbesondere unterschiedlicher Breite an den Stellen, an denen sie in dem Modulaufnahmerahmen fixiert werden sollen, aufnehmbar sein sollen. Dadurch, dass der Mechanismus an den Modulen angeordnet ist, kann vorteilhafterweise erreicht werden, dass die Lage der Mechanismen nicht durch den Modulaufnahmerahmen vorgegeben wird.

Weiter gelingt die Lösung der gestellten Aufgabe durch ein System bestehend aus dem Mechanismus und einem Modul oder einem Modulaufnahmerahmen. In solch einem System können Mechanismus, Modul und Modulaufnahmerahmen zum reibungslosen Funktionieren aufeinander abgestimmt werden.

Schließlich gelingt die Lösung der Aufgabe durch einen Receiver oder Interchangeable-Test-Adapter für ein Mass-Interconnect, wobei der Receiver oder der Interchangeable-Test-Adapter einen Modulaufnahmerahmen mit zwei oder mehr der oben beschriebenen Mechanismen oder das oben beschriebene System aufweist. Receiver und Interchangeable-Test-Adapter von Mass-Interconnects enthalten häufig Module, die je nach Messanforderung regelmäßig ausgetauscht werden müssen. Deshalb ist die Erfindung gerade in diesen Anwendungsfällen besonders vorteilhaft.

Ein "Mass-Interconnect" im Sinne der vorliegenden Erfindung ist eine Steckverbinderschnittstelle zum Verbinden eines oder mehrerer Testinstrumente mit einem oder mehreren Testobjekten (das Testobjekt wird in diesem Zusammenhang auch als Device-Under-Test, DUT, oder Unit-Under-Test, UUT, bezeichnet). Das bevorzugte Mass-Interconnect ist Teil eines Automatic-Test-Equipment (auch als ATE bezeichnet), umfassend ein Mass-Interconnect und ein oder mehrere Testinstrumente. Das ATE kann auch einen oder mehrere PCs (Personal-Computer) zum Steuern des oder der Testinstrumente umfassen. Vorzugsweise genügen eines oder mehrere der Testinstrumente einer oder mehreren der folgenden Spezifikationen: PXI (PCI eXtensions for Instrumentation), VXI (VME eXtensions for Instrumentation), LXI (LAN eXtensions for Instrumentation), GPIB (General-Purpose-Interface-Bus), SCXI (Signal-Conditioning-Extension-for-Instrumentation), PCI (Peripheral-Component-Interconnect).

Ein "Receiver" im Sinne der vorliegenden Erfindung ist die Komponente des Mass-Interconnect, die mit einem auswechselbaren Testadapter (auch als Interchangeable-Test-Adapter, ITA, bezeichnet) verbunden werden kann, um den Testadapter an das oder die Testinstrumente anzuschließen. Im Sinne der vorliegenden Erfindung ist ein "Interchangeable-Test-Adapter" die Komponente des Mass-Interconnect, die einerseits auswechselbar mit dem Receiver und andererseits mit dem oder den eigentlichen, in der Regel am Interchangeable-Test-Adapter auswechselbaren Testobjekt(e) verbunden werden kann, um das Testobjekt über den Interchangeable-Test-Adapter und den Receiver an das oder die Testinstrumente anzuschließen.

### Bevorzugte Ausgestaltungen der Erfindung

Vorteilhafte Aus- und Weiterbildungen, welche einzeln oder in Kombination miteinander eingesetzt werden können, sind Gegenstand der abhängigen Ansprüche und der nachfolgenden Beschreibung.

Die Feder des bevorzugten Mechanismus ist als Federplatte ausgebildet, wobei die Federplatte nicht notwendigerweise eben sein muss sondern auch gekrümmt sein kann, zum Beispiel in einer S-Form oder einer C-Form. Die Feder ist vorzugsweise aus einem Metall gefertigt, besonders vorzugsweise aus Federstahl. Mithin ist die bevorzugte Federplatte ein Federblech. Die Erfindung schließt aber auch Ausführungen der Feder und der Federplatte aus anderen Materialien, zum Beispiel aus einem elastischen Kunststoff oder aus Gummi ein. So kann zum Beispiel auch ein elastisch komprimierbares Stück Gummi, das den Riegel in eine der beiden Stellungen Offenstellung oder Sperrstellung vorspannt, eine Feder im Sinne der Erfindung sein. Die Feder kann auch zum Beispiel als Spiralfeder oder als Schraubenfeder ausgeführt sein.

In einer bevorzugten Ausführung der Erfindung ist die Feder mit dem Riegel einteilig ausgeführt. Es ist ein erreichbarer Vorteil dieser Ausführung der Erfindung, dass die Anzahl der Komponenten des Mechanismus reduziert werden kann. Besonders vorzugsweise ist diese Kombination aus Riegel und Feder aus einer Platte, besonders vorzugsweise einem Blech gebildet, wobei ein Abschnitt der Platte oder des Blechs den Riegel und ein anderer die Feder bildet. Besonders vorzugsweise weist die Kombination aus Feder und Riegel, also zum Beispiel die Platte oder das Blech, welche(s) Feder und Riegel bildet, noch einen weiteren Abschnitt auf, mit dem sie an dem Modul oder dem Modulaufnahmerahmen befestigt ist.

Der bevorzugte Riegel weist mindestens eine, besonders vorzugsweise zwei Laschen auf, mit denen der Riegel mit einem Gegenriegel, der an der Komponente der beiden Komponenten Modul oder Modulrahmen, an der der Riegel sich nicht befindet, angeordnet ist, zusammenwirkt, um das Modul in dem Modulaufnahmerahmen zu fixieren. Der Gegenriegel ist vorzugsweise unbeweglich an der Komponente der beiden Komponenten Modul und Modulrahmen, an der der Riegel des Mechanismus nicht angeordnet ist, vorgesehen.

Der bevorzugte Riegelhalter ist so ausgebildet und in dem Mechanismus angeordnet, dass eine Bewegung des Riegelhalters von der Lösestellung in die Sperrstellung den Riegel entgegen der Vorspannung der Feder in eine der beiden Stellungen Offenstellung oder Sperrstellung bewegt. Besonders vorzugsweise bewegt der Riegelhalter durch die Bewegung von seiner Lösestellung in seine Haltestellung den Riegel von seiner Offenstellung in seine Sperrstellung. Die Erfindung schließt aber auch Ausführungen ein, in denen der Riegelhalter durch seine Bewegung von der Lösestellung in die Haltestellung den Riegel von der Sperrstellung in die Offenstellung bewegt. Der bevorzugte Riegelhalter ist außerdem so ausgebildet und in dem Mechanismus angeordnet, dass eine Bewegung des Riegelhalters von der Sperrstellung in die Lösestellung den Riegel freigibt, sodass der Riegel durch die Kraft der Feder in eine der beiden Stellungen Sperrstellung oder Offenstellung bewegt. Besonders vorzugsweise bewegt der Riegel sich aufgrund der Bewegung des Riegelhalters von seiner Haltestellung in seine Lösestellung aufgrund der Kraft der Feder von seiner Sperrstellung in seine Offenstellung. Die Erfindung schließt aber auch Ausführungen ein, in denen der Riegel sich aufgrund der Bewegung des Riegelhalters von seiner Haltestellung in seine Lösestellung und aufgrund der Kraft der Feder von seiner Offenstellung in seine Sperrstellung bewegt. Durch diese Ausführungen der Erfindung ist vorteilhafterweise erreichbar, dass sowohl zum Bewegen des Riegels von der Offenstellung in die Sperrstellung als auch für die Bewegung des Riegels von der Sperrstellung in die Offenstellung jeweils lediglich der Riegelhalter bewegt werden muss.

Der Riegelhalter ist vorzugsweise schwenkbar ausgebildet. Dadurch kann vorteilhafterweise erreicht werden, dass der Riegelhalter lediglich durch Schwenken von der Haltestellung in die Lösestellung und umgekehrt von der Lösestellung in die Haltestellung gebracht werden kann. Vorzugsweise erstreckt sich die Schwenkachse senkrecht zu einem Bewegungspfad des Riegelhalters zwischen Offenstellung und Sperrstellung. Der Riegelhalter greift vorzugsweise in der Sperrstellung an den Riegel an. Dabei verläuft die Tangente senkrecht zur Schwenkachse des Riegelhalters besonders vorzugsweise in der Sperrstellung an der Stelle, an der der Riegelhalter an den Riegel angreift, senkrecht zur Richtung der Kraft, die der Riegel aufgrund der Vorspannung der Feder auf den Riegelhalter ausübt. Auf diese Weise kann erreicht werden, dass der Riegel in der Sperrstellung keine in eine Schwenkrichtung verlaufende Kraftkomponente auf den Riegelhalter ausübt. Dies kann dazu beitragen, dass die Sperrstellung eine Ruhestellung ist.

Bei einem bevorzugten Mechanismus mit einem schwenkbaren Riegelhalter sind die Haltestellung und die Lösestellung um einen Winkel von weniger als 280° voneinander beabstandet, besonders vorzugsweise um 100° oder weniger. Bei einem bevorzugten Mechanismus mit einem schwenkbaren Riegelhalter sind die Haltestellung und die Lösestellung um einen Winkel von mehr als 80° voneinander beabstandet, z. B. zwischen 80 und 100°. Alle Gradangaben sind auf einen Vollkreis von 360° bezogen.

Der bevorzugte Riegelhalter weist einen Exzenter auf. Dadurch kann der von der Schwenkachse entfernte Teil des Exzenters vorteilhafterweise an den Riegel angreifen, um ihn gegen die Kraft der Feder in der Sperrstellung zu halten. Vorzugsweise hält der Exzenter dabei in seiner ausgefahrenen Stellung also bei seiner hohen Höhe, den Riegel gegen die Kraft der Feder in der Sperrstellung.

Zum Beispiel kann der Riegelhalter als Schraube oder als Bolzen mit einem exzentrischen Kopf ausgebildet sein. Die Schraube oder der Bolzen ist besonders vorzugsweise in einem Loch des Moduls oder des Modulaufnahmerahmens schwenkbar gelagert. Im Fall, dass der Riegelhalter als Schraube ausgebildet ist, ist das Loch vorzugsweise mit einem mit dem Gewinde der Schraube schraubbar korrespondierenden Innengewinde ausgestattet.

In einer Ausführung der Erfindung weist der Mechanismus einen oder mehrere Anschläge auf, um die Bewegung des Riegelhalters zu begrenzen. Besonders vorzugsweise ist ein Anschlag so angeordnet, dass er verhindert, dass der Riegelhalter auf dem Weg von der Lösestellung in die Haltestellung über die Haltestellung hinaus bewegt werden kann. Mit dieser Ausführung der Erfindung ist vorteilhafterweise erreichbar, dass der Benutzer den Riegelhalter zuverlässig in die Haltestellung bringen kann. Zusätzlich oder alternativ ist besonders vorzugsweise ein Anschlag so angeordnet, dass er verhindert, dass der Riegelhalter auf dem Weg von der Haltestellung in die Lösestellung über die Lösestellung hinaus bewegt werden kann. Mit dieser Ausführung der Erfindung ist vorteilhafterweise erreichbar, dass der Benutzer den Riegelhalter zuverlässig in die Lösestellung bringen kann.

Ein bevorzugter Mechanismus umfasst Rastmittel zum lösbaren Einrasten des Riegels in eine oder mehrere Raststellungen. Dabei bedeutet "lösbares Einrasten", dass die Rastmittel einen mechanischen Widerstand verursachen, der überwunden werden muss, um den Riegelhalter aus der Raststellung herauszubewegen. Bei einem schwenkbaren Riegelhalter ist der Widerstand vorzugsweise ein Widerstand in eine Schwenkrichtung um die Schwenkachse. Eine bevorzugte Raststellung fällt mit der Haltestellung des Riegelhalters zusammen. Eine zusätzliche oder alternativ bevorzugte Raststellung fällt mit der Lösestellung des Riegelhalters zusammen.

Die Rastmittel können zum Beispiel durch eine Nase oder eine Vertiefung in einen zum Modul oder Modulaufnahmerahmen gerichteten Teil des Riegels und einer damit korrespondierend zusammenwirkenden Vertiefung beziehungsweise Nase in dem Modul oder Modulaufnahmerahmen gebildet sein. Der Riegel ist dabei vorzugsweise in Richtung des Moduls oder des Modulrahmens durch eine Rastfeder (zum Beispiel einen Federring oder eine Schraubenfeder), die den zu überwindenden mechanischen Widerstand verursacht, vorgespannt. In einer beispielhaften Ausführung ist der Riegelhalter durch einen Bolzen geschaffen, der in einen Durchloch des Modulaufnahmerahmens oder des Moduls schwenkbar und entlang seiner Längsachse beweglich gelagert ist. Auf der einen Seite ist der Bolzen mit einem Exzentrischen Kopf ausgestattet. Auf der von dem Kopf wegweisenden Seite des Durchlochs ist eine Rastfeder angeordnet, die einerseits an dem Modulrahmen oder Modul und andererseits an dem von dem Exzenter wegweisenden Ende des Bolzens festgelegt ist, um den Exzenter in Richtung Modul oder Modulrahmen vorzuspannen.

In einer bevorzugten Ausführung der Erfindung spannt die Feder den Riegel in der Offenstellung vor und der Riegelhalter hält in seiner Haltestellung den Riegel in dessen Sperrstellung zurück. Hierdurch lässt sich vorteilhafterweise eine besonders einfache Konstruktion eines erfindungsgemäßen Mechanismus realisieren, bei der der Riegelhalter auf der vom Modul (falls der Mechanismus auf dem Modulaufnahmerahmen angeordnet ist) oder vom Modulaufnahmerahmen (falls der Mechanismus auf dem Modul angeordnet ist) abgewandten Seite des Riegels angeordnet ist und die Sperrstellung des Riegels im Vergleich zur Offenstellung weiter zum Modul bzw. Modulrahmen hin liegt. Alternativ spannt der Riegelhalter den Riegel der Sperrstellung vor. In diesem Fall hält der Riegelhalter in seiner Haltestellung den Riegel in dessen Offenstellung zurück.

Der Mechanismus ist vorzugsweise entweder an dem Modulaufnahmerahmen oder an dem Modul angeordnet. Jedoch umfasst die Erfindung auch Ausführungen, bei denen ein Teil der Komponenten des Mechanismus an dem Modulaufnahmerahmen und ein Teil an dem Modul angeordnetsind. In einer bevorzugten Ausführung der letztgenannten Art sind Riegel und Feder an einer der beiden Komponenten Modulaufnahmerahmen oder Modul und der Riegelhalter an der anderen dieser beiden Komponenten angeordnet.

Der bevorzugte Modulaufnahmerahmen ist mit Positionierstiften oder Positionierlöchern ausgestattet, die mit Positionierlöchern beziehungsweise Positionierstiften des Moduls zusammenwirken können. Dadurch kann es dem Benutzer vorteilhafterweise erleichtert werden, die Module in der vorgesehenen Position in den Modulaufnahmerahmen einzusetzen. Besonders vorzugsweise sind der oder die Positionierstifte an dem Modul oder dem Modulrahmen angeschraubt. Besonders vorzugsweise dienen der oder die angeschraubten Positionierstifte gleichzeitig der Fixierung der Feder oder der einteiligen Kombination aus Feder und Riegel an dem Modul oder dem Modulrahmen.

Der bevorzugte Modulaufnahmerahmen bietet Platz für mehr als ein Modul, zum Beispiel vier oder mehr, acht oder mehr oder zwölf oder mehr Module. Ein bevorzugter Modulaufnahmerahmen ist mit mehr als einem erfindungsgemäßen Mechanismus ausgestattet, zum Beispiel mit acht oder mehr, 16 oder mehr oder 32 oder mehr Mechanismen. Besonders vorzugsweise weist der Modulaufnahmerahmen zwei Mechanismen pro aufnehmbarem Modul auf, besonders vorzugsweise an zwei gegenüberliegenden Leisten des Modulaufnahmerahmens; so ist vorteilhafterweise eine sichere Fixierung der Module erreichbar. Durch das Vorsehen mehrerer Mechanismen ist auch vorteilhaft erreichbar, dass mehrere Module unabhängig voneinander in dem Modulaufnahmerahmen fixiert oder gelöst werden können, insbesondere, um die Module unabhängig voneinander in den Modulaufnahmerahmen einzusetzen oder aus ihm zu entnehmen. Der bevorzugte Modulaufnahmerahmen ist Teil eines Receivers oder eines Interchangeable-Test-Adapters eines Mass-Interconnect.

Wenn ein Modul mit dem erfindungsgemäßen Mechanismus ausgestattet ist, ist das Modul vorzugsweise in den Modulaufnahmerahmen eines Receivers oder eines Interchangeable-Test-Adapters eines Mass-Interconnect aufnehmbar. Das bevorzugte Modul ist mit Positionierstiften oder Positionierlöchern ausgestattet, die mit den Positionierlöchern beziehungsweise Positionierstiften des Modulaufnahmerahmens zusammenwirken können, um es dem Benutzer zu erleichtern, das oder die Module in der vorgesehenen Position in den Modulaufnahmerahmen einzusetzen. Besonders vorzugsweise sind der oder die Positionierstifte an dem Modul angeschraubt. Besonders vorzugsweise dienen der oder die angeschraubten Positionierstifte gleichzeitig der Fixierung der Feder oder der einteiligen Kombination aus Feder und Riegel an dem Modul.

Der bevorzugte erfindungsgemäße Receiver weist einen Modulaufnahmerahmen zur Aufnahme von mindestens einem, vorzugsweise mehreren, auswechselbaren Modulen auf, die jeweils einen Steckverbinder zum Verbinden mit einem oder mehreren Gegensteckverbindern des Interchangeable-Test-Adapters aufweisen. Vorzugsweise sind die Gegensteckverbinder Teile von Modulen des Interchangeable-Test-Adapters, wobei besonders vorzugsweise jedes Modul mit einem in den Receiver aufgenommenen Modul in der Weise korrespondiert, dass im vorgesehenen Betrieb der Gegensteckverbinder des Moduls der Interchangeable-Test-Adapters mit dem korrespondierenden Steckverbinder des in dem Receiver aufgenommenen Moduls verbunden wird. In gleicher Weise weist ein bevorzugter Interchangeable-Test-Adapter einen Modulaufnahmerahmen zur Aufnahme von mindestens einem, vorzugsweise mehreren, auswechselbaren Modulen auf, die jeweils einen Gegensteckverbinder zum Verbinden mit einem oder mehreren Steckverbindern des Receivers aufweisen.

### Kurzbeschreibung der Zeichnungen

Weitere vorteilhafte Ausgestaltungen werden nachfolgend anhand mehrerer in den Zeichnungen dargestellten Ausführungsbeispielen, auf welche die Erfindung jedoch nicht beschränkt ist, näher beschrieben.

Es zeigt schematisch:
- Figur 1: einen Ausschnitt eines erfindungsgemäßen Modulaufnahmerahmens bestehend aus einer oberen und einer unteren Modulaufnahmeleiste, die jeweils mit erfindungsgemäßen Mechanismen ausgestattet sind;
- Figur 2: den in Figur 1 dargestellten Teil des Modulaufnahmerahmens mit einem in den Rahmen eingesetzten Modul, wobei die Riegel der Mechanismen in der Offenstellung und die Riegelhalter in der Lösestellung sind;
- Figur 3: den in Figur 1 dargestellten Teil des Modulaufnahmerahmens mit einem in den Rahmen eingesetzten Modul, wobei die Riegel der Mechanismen in der Sperrstellung und die Riegelhalter in der Haltestellung sind;
- Figur 4: einen Querschnitt durch eine Aufnahmeleiste des Modulaufnahmerahmens der vorherigen Figuren, wobei die Riegel der Mechanismen in der Offenstellung und die Riegelhalter in der Lösestellung sind;
- Figur 5: der in der Figur 4 dargestellte Querschnitt durch die Aufnahmeleiste und den erfindungsgemäßen Mechanismus, jedoch diesmal mit eingesetztem Modul; und
- Figur 6: den Querschnitt der Figur 5, wobei sich diesmal jedoch der Riegel in der Sperrstellung und der Riegelhalter in der Haltestellung befindet.

### Detaillierte Beschreibung von Ausführungen der Erfindung

Bei der nachfolgenden Beschreibung von bevorzugten Ausführungsformen der vorliegenden Erfindung bezeichnen gleiche Bezugszeichen gleiche oder vergleichbare Komponenten.

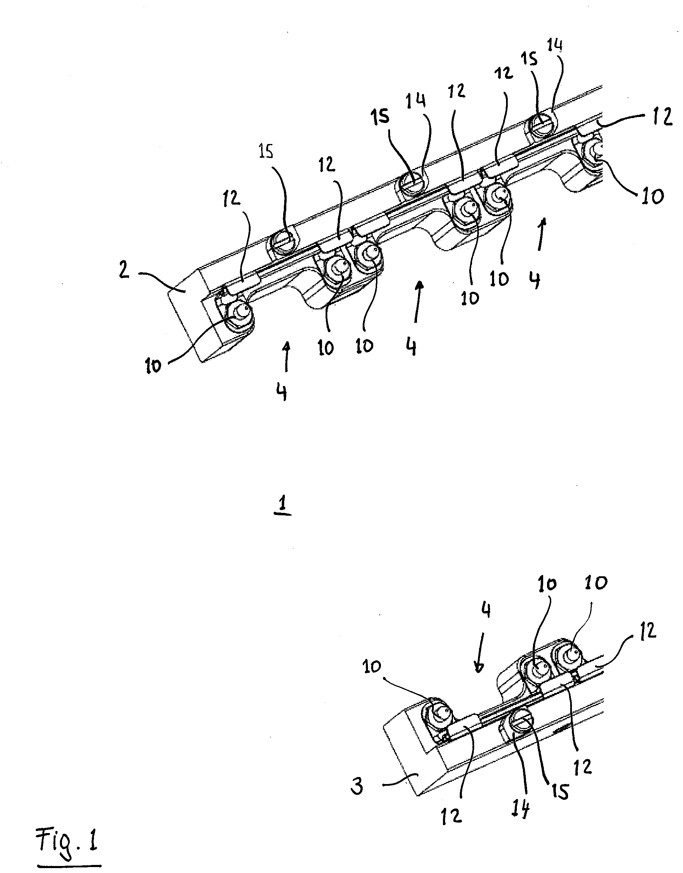

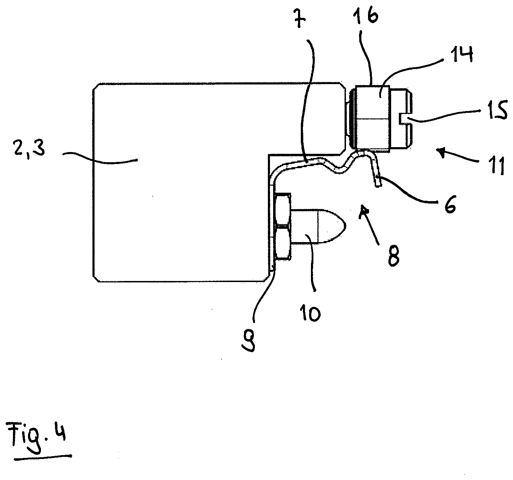

Der Modulaufnahmerahmen 1, der in dem Ausführungsbeispiel der Figuren 1 bis 6 dargestellt ist, besteht aus einer oberen 2 und einer unteren Aufnahmeleiste 3. Jede dieser Leisten 2, 3 ist mit mehreren Mechanismen 4 zum Fixieren eines in den Modulaufnahmerahmen 1 eingesetzten Moduls 5 an dem Modulaufnahmerahmen 1 und zum Lösen des Moduls 5 zur Entnahme aus dem Modulaufnahmerahmen 1 angeordnet. In den Figuren 1 bis 3 sind an der oberen Aufnahmeleiste 2 drei und auf der unteren Aufnahmeleiste 3 zwei dieser Mechanismen 4 dargestellt.

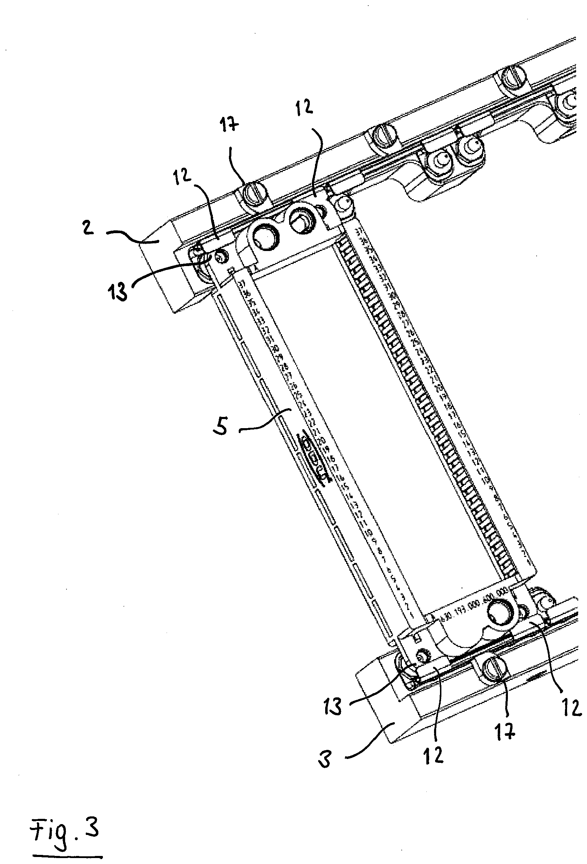

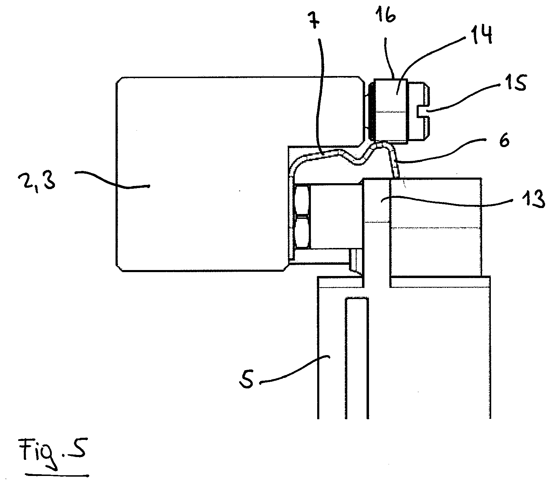

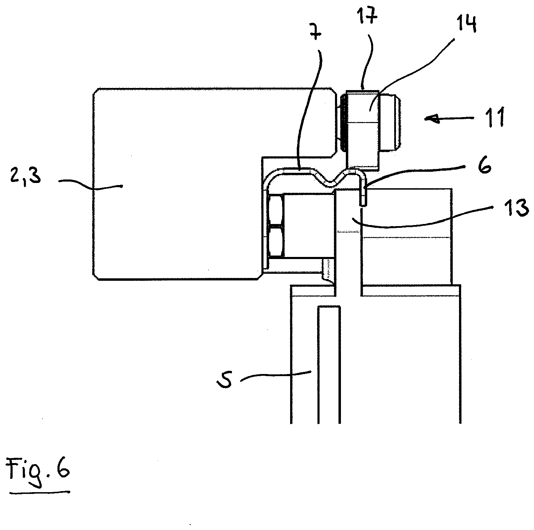

Jeder Mechanismus 4 weist einen Riegel 6 auf, der gemeinsam mit einer Feder 7 einstückig durch ein gebogenes Stück Federblech 8 gebildet wird. Der vordere Teil dieses Blechs 8 bildet den Riegel 6, ein mittlerer Teil die Feder 7 und ein unterer Teil einen Fuß 9, mit dem die Feder 7 durch Positionierstifte 10 an einer der Aufnahmeleisten 2, 3 festgeschraubt ist. Die Feder 7 ist S-förmig gekrümmt, um zu verhindern, dass sie in der Offenstellung an die Aufnahmeleiste 2, 3 anschlägt. Der Riegel 6 weist einen ersten Teil auf, mit dem er an einen Riegelhalter 11 anschlägt und einen dazu abgewinkelten Teil mit zwei Laschen 12, die, wie am besten in den Figuren 5 und 6 zu sehen ist, mit einem Gegenriegel 13 des Moduls 5 aneinander angreifend zusammenwirken können, um das Modul 5 in dem Modulaufnahmerahmen zu fixieren. Dazu kann der Riegel 6 entgegen der Kraft der Feder 7 von einer Offenstellung, die in den Figuren 1, 2, 4 und 5 dargestellt ist, in eine Sperrstellung, die in den Figuren 3 und 6 dargestellt ist, bewegt werden. Außerdem kann die Kraft der Feder 7 den Riegel 6 von der Sperrstellung zurück in die Offenstellung bewegen, soweit er nicht von einem Riegelhalter 11 daran gehindert wird. In der Offenstellung geben die Laschen des Riegels den Gegenriegel frei, sodass das Modul 5 aus dem Modulaufnahmerahmen 1 entnommen werden kann.

Der Riegelhalter 11 ist als Exzenterschraube ausgebildet, die einen exzentrischen Kopf 14 aufweist, sowie einen in den Figuren nicht dargestellten Schaft, der ein Außengewinde aufweist, mit dem die Exzenterschraube in ein mit einem Innengewinde ausgestatteten Loch der Aufnahmeleiste 2, 3 geschraubt ist. Außerdem weist die Exzenterschraube auf ihrem Kopf 14 einen Schlitz 15 auf, in den ein Schraubenzieher eingesetzt werden kann, um die Exzenterschraube um ihre Längsachse von der in den Figuren 1, 2, 4 und 5 dargestellten Lösestellung in die in den Figuren 3 und 6 dargestellte Haltestellung zu schwenken oder zurück von der Haltestellung in die Lösestellung. Haltestellung und Lösestellung schließen einen Winkel von 90° zueinander ein. Durch die Bewegung des exzentrischen Kopfes 14 von der Lösestellung in die Haltestellung wird der Riegel 6 gegen die Kraft der Feder 7 von seiner Offenstellung in seine Sperrstellung bewegt. In der Sperrstellung bewirkt die Feder 7, dass der Riegel 6 auf den Riegelhalter 11 eine Kraft ausübt, die gerade senkrecht zu einer durch die Kontaktstelle zwischen Riegel 6 und Riegelhalter 11 verlaufenden Tangente des Riegelhalters 11, die senkrecht zur Schwenkachse des Riegelhalters 11 verläuft, angreift. Dadurch wird erreicht, dass der Riegel 6 keine in eine Schwenkrichtung des Riegelhalters 11 verlaufende Kraft auf den Riegelhalter 11 ausübt.

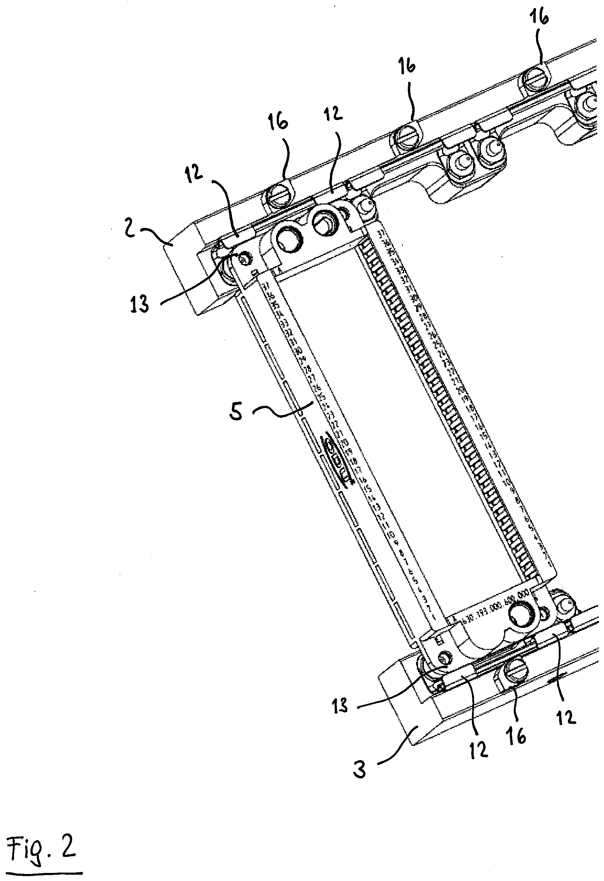

Eine in den Figuren nicht dargestellten Ausführung des Mechanismus 4 weist außerdem einen Anschlag auf, der parallel zu dem Riegel 6 auf der gegenüberliegenden Seite des Riegelhalters 11 an den Riegelhalter 11 angrenzend angeordnet ist. Dieser wirkt mit dem in Figur 2 bezeichneten oberen Rand 16 des exzentrischen Kopfes 14 und dem in Figur 3 bezeichneten oberen Rand 17 des Exzenters in der Weise zusammen, dass der Exzenter bei der Bewegung von der Haltestellung in die Lösestellung nicht über die Lösestellung hinaus und bei der Bewegung von der Lösestellung in die Haltestellung nicht über die Haltestellung hinaus bewegt werden kann.

In einer ebenfalls nicht in den Figuren dargestellten Ausführung des Mechanismus 4 ist ein Rastmittel zum lösbaren Einrasten des Riegelhalters 11 in der Haltestellung und in der Lösestellung vorgesehen. Diese bestehen aus einer Nase, die an der der Aufnahmeleiste 2, 3 zugewandten Seite des exzentrischen Kopfes 14 des Riegelhalters 11 angeordnet ist, und zwei korrespondierenden Vertiefungen der Oberfläche der Aufnahmeleiste 2, 3, die so angeordnet sind, dass die Nase in der Haltestellung des Riegelhalters 11 in eine dieser Vertiefungen und in der Lösestellung des Riegelhalters in die andere der beiden Vertiefungen eingreifen kann. Der Schaft des Riegelhalters ist in diesem Fall als Bolzen ohne Schraubgewinde ausgebildet und das Loch in der Aufnahmeleiste 2, 3 ist ein Durchloch, wobei der Bolzen das Durchloch vollständig und darüber hinaus durchmisst. Auf der dem Kopf gegenüberliegenden Seite der Aufnahmeleiste 2, 3 ist eine Schraubenfeder als Rastfeder angeordnet, die einerseits an dieser Seite der Aufnahmeleiste festliegt und auf ihrer anderen Seite an dem Ende des Bolzens, sodass der Kopf 14 mittels der Feder gegen die Aufnahmeleiste 2, 3 vorgespannt ist. Die Feder verursacht dann einen Widerstand, der überwunden werden muss, um den Riegelhalter 11 aus der Haltestellung oder der Lösestellung herauszubewegen.

In dem in den Figuren 1 bis 6 dargestellten Ausführungsbeispiel der Erfindung ist der Riegelhalter 11 auf der von dem Modul 5 abgewandten Seite des Riegels 6 angeordnet. Die Feder 7 des Riegels 6 spannt diesen in seiner Offenstellung vor und der Riegelhalter 11 hält in seiner Haltestellung den Riegel 6 in dessen Sperrstellung zurück.

In einer zweiten, in den Figuren nicht dargestellten Ausführung der Erfindung ist der Riegelhalter 11 zwischen Riegel 6 und Modul 5 angeordnet und die Feder 7 spannt den Riegel 6 in die Sperrstellung vor. Dann hält der Riegelhalter 11 in seiner Haltestellung den Riegel 6 in seiner Offenstellung zurück.

In dem Ausführungsbeispiel der Figuren 1 bis 6 ist der Mechanismus 4 an dem Modulrahmen 1 angeordnet. In einer alternativen, dritten Ausführung der Erfindung ist der beschriebene Mechanismus 4 stattdessen an dem Modul 5 angeordnet und der Gegenriegel 13 ist an einer Aufnahmeleiste 2, 3 des Modulaufnahmerahmens 5 angeordnet.

In einer vierten Ausführung der Erfindung sind Feder 7 und Riegel 6, wie in den Figuren 1 bis 6 dargestellt, an der Aufnahmeleiste 2, 3 angeordnet, wobei die Feder 7 den Riegel 6 aber in seine Sperrstellung vorspannt. Der Riegelhalter 11 ist an dem Modul 5 angeordnet, und zwar angrenzend an den Riegel 6, sodass der Riegelhalter 11 in seiner Haltestellung den Riegel 6 gegen die Vorspannung der Feder 7 in seiner Offenstellung hält.

Eine fünfte Ausführungsform ist mit der vierten Ausführungsform identisch, mit dem Unterschied dass Aufnahmeleiste 2, 3 und Modul 5 in Bezug auf den Mechanismus 4 vertauscht sind, Riegel 6 und Feder 7 also wie in der dritten Ausführungsform an dem Modul 5, der Riegelhalter 11 aber an der Aufnahmeleiste 2, 3 angeordnet ist.

Der in den Figuren 1 bis 6 dargestellte Modulaufnahmerahmen 1 ist Teil eines Receivers für ein Mass-Interconnect. Das Modul 5 ist in dieser Ausführung ein austauschbares Modul 5 zum Anschluss eines oder mehrerer Testinstrumente mittels des Mass-Interconnect. Dazu ist das Modul 5 als Steckverbinder mit in der Figur nicht dargestellten Verbindungselementen wie Stiften und Buchsen ausgestattet, die mit korrespondierenden Verbindungselementen eines Interchangeable-Test-Adapters des Mass-Interconnect zusammenwirken können.

In einer alternativen Ausführung der Erfindung ist der in den Figuren 1 bis 6 dargestellte Modulaufnahmerahmen 1 Teil eines Interchangeable-Test-Adapters für ein Mass-Interconnect. Das Modul 5 ist ein austauschbares Modul zum Anschluss eines oder mehrerer Testobjekte mittels des Mass-Interconnect. Dazu ist das Modul 5 als Steckverbinder mit in der Figur nicht dargestellten Verbindungselementen wie Stiften und Buchsen ausgestattet, die mit korrespondierenden Verbindungselementen eines Receivers des Mass-Interconnect zusammenwirken können.

Die in der vorstehenden Beschreibung, den Ansprüchen und den Zeichnungen offenbarten Merkmale können sowohl einzeln als auch in beliebiger Kombination für die Verwirklichung der Erfindung in ihren verschiedenen Ausführungsformen von Bedeutung sein.

### Bezugszeichenliste

- 1: Modulaufnahmerahmen
- 2: Obere Aufnahmeleiste
- 3: Untere Aufnahmeleiste
- 4: Mechanismus
- 5: Modul
- 6: Riegel
- 7: Feder
- 8: Federblech
- 9: Fuß
- 10: Positionierstift
- 11: Riegelhalter
- 12: Lasche
- 13: Gegenriegel
- 14: Exzentrischer Kopf
- 15: Schlitz
- 16: Oberer Rand in des exzentrischen Kopfes in Lösestellung
- 17: Oberer Rand in des exzentrischen Kopfes in Haltestellung

## Patentansprüche

1. Mechanismus (4) zum Fixieren eines in einen Modulaufnahmerahmen (1) eingesetzten Moduls (5) an dem Modulaufnahmerahmen (1) und Lösen des Moduls (5) zur Entnahme aus dem Modulaufnahmerahmen (1), aufweisend einen an dem Modul (5) oder dem Modulaufnahmerahmen (1) angeordneten Riegel (6), der zwischen einer Offenstellung und einer Sperrstellung des Riegels (6) hin- und herbewegt werden kann, und eine Feder (7), wobei der Mechanismus (4) außerdem einen Riegelhalter (11) aufweist, der zwischen einer Haltestellung, in der er den Riegel (6) gegen die Vorspannung der Feder (7) zurückhält, und einer Lösestellung, in der er den Riegel (6) nicht gegen die Vorspannung der Feder (7) zurückhält, hin- und herbewegt werden kann und so ausgebildet und angeordnet ist, dass sowohl die Haltestellung als auch die Lösestellung eine Ruhestellung des Riegelhalters (11) ist, **dadurch gekennzeichnet, dass** die Feder (7) dazu vorgesehen ist, um den Riegel (6) in eine der beiden Stellungen Offenstellung oder Sperrstellung vorzuspannen,
wobei der Riegelhalter (11) so ausgebildet und in dem Mechanismus so angeordnet ist, dass eine Bewegung des Riegelhalters (11) von der Haltestellung in die Lösestellung den Riegel (6) freigibt, so dass der Riegel (6) sich durch die Kraft der Feder (7) von seiner Sperrstellung in seine Offenstellung oder von seiner Offenstellung in seine Sperrstellung bewegt.

2. Mechanismus (4) nach Anspruch 1, **dadurch gekennzeichnet, dass** die Feder (7) als Federplatte ausgebildet ist.

3. Mechanismus (4) nach einem der vorhergehenden Ansprüche, **dadurch gekennzeichnet, dass** die Feder (7) und der Riegel (6) einteilig ausgeführt sind.

4. Mechanismus (4) nach einem der vorhergehenden Ansprüche, **dadurch gekennzeichnet, dass** der Riegelhalter (11) schwenkbar ausgebildet ist.

5. Mechanismus (4) nach Anspruch 4, **dadurch gekennzeichnet, dass** der Riegelhalter (11) einen Exzenter aufweist.

6. Mechanismus (4) nach einem der vorangehenden Ansprüche, **dadurch gekennzeichnet, dass** der Mechanismus (4) einen oder mehrere Anschläge aufweist, um die Bewegung des Riegelhalters (11) zu begrenzen.

7. Mechanismus (4) nach einem der vorangehenden Ansprüche, **dadurch gekennzeichnet, dass** der Mechanismus (4) Rastmittel zum lösbaren Einrasten des Riegelhalters (11) in eine oder mehrere Raststellungen aufweist.

8. Mechanismus (4) nach einem der vorangehenden Ansprüche, **dadurch gekennzeichnet, dass** die Feder (7) den Riegel (6) in die Offenstellung vorspannt.

9. Modulaufnahmerahmen (1) mit dem Mechanismus (4) nach einem der vorhergehenden Ansprüche.

10. Modulaufnahmerahmen (1) nach Anspruch 9, **dadurch gekennzeichnet, dass** er zwei oder mehr Mechanismen nach einem der Ansprüche 1 bis 8 umfasst.

11. Modul (5) mit dem Mechanismus (4) nach einem der Ansprüche 1 bis 8.

12. System bestehend aus einem Mechanismus (4) nach einem der Ansprüche 1 bis 8, einem Modul (5) und einem Modulaufnahmerahmen (1).

13. System nach Anspruch 12, **dadurch gekennzeichnet, dass** die Komponente der beiden Komponenten Modul (5) und Modulaufnahmerahmen (1), an der der Riegel (6) des Mechanismus (4) nicht angeordnet ist, einen Gegenriegel (13) aufweist, der mit dem Riegel (6) in dessen Schließstellung zusammenwirkt, um das Modul (5) in dem Modulaufnahmerahmen (1) zu fixieren.

14. Receiver oder Interchangeable-Test-Adapter für ein Mass-Interconnect, wobei der Receiver oder der Interchangeable-Test-Adapter einen Modulaufnahmerahmen (1) nach Anspruch 10 oder ein System nach Anspruch 12 oder 13 aufweist.

## Claims

1. Mechanism (4) for securing a module (5) inserted into a module receiving frame (1) to the module receiving frame (1) and releasing the module (5) for removal from the module receiving frame (1), comprising a catch (6) arranged on the module (5) or the module receiving frame (1), which catch (6) may be moved to and fro between an open position and a locking position of the catch (6), and a spring (7), wherein the mechanism (4) further comprises a catch holder (11), which may be moved to and fro between a retaining position, in which it holds the catch (6) back against the preloading of the spring (7), and a release position, in which it does not hold the catch (6) back against the preloading of the spring (7) and is configured and arranged such that both the retaining position and the release position are neutral positions of the catch holder (11), **characterized in that** the spring (7) is provided to preload the catch (6) into one of the two positions, open position or locking position,
wherein the catch holder (11) is configured and arranged in the mechanism such that a movement of the catch holder (11) from the retaining position into the release position releases the catch (6) so that the catch (6) moves from its locking position into its open position or from its open position into its locking position by the force of the spring (7).

2. Mechanism (4) according to claim 1, **characterized in that** the spring (7) is configured as a spring plate.

3. Mechanism (4) according to one of the preceding claims, **characterized in that** the spring (7) and the catch (6) are embodied in one piece.

4. Mechanism (4) according to one of the preceding claims, **characterized in that** the catch holder (11) is of swivellable configuration.

5. Mechanism (4) according to claim 4, **characterized in that** the catch holder (11) comprises an eccentric.

6. Mechanism (4) according to one of the preceding claims, **characterized in that** the mechanism (4) comprises one or more limit stops, for restricting the movement of the catch holder (11).

7. Mechanism (4) according to one of the preceding claims, **characterized in that** the mechanism (4) comprises detent means for releasable snapping-in of the catch holder (11) into one or more detent positions.

8. Mechanism (4) according to one of the preceding claims, **characterized in that** the spring (7) preloads the catch (6) into the open position.

9. Module receiving frame (1) having the mechanism (4) according to one of the preceding claims.

10. Module receiving frame (1) according to claim 9, **characterized in that** it comprises two or more mechanisms according to one of the claims 1 to 8.

11. Module (5) having the mechanism (4) according to one of the claims 1 to 8.

12. System consisting of a mechanism (4) according to one of the claims 1 to 8, a module (5) and a module receiving frame (1).

13. System according to claim 12, **characterized in that** the component of the two components module (5) and module receiving frame (1) on which the catch (6) of the mechanism (4) is not arranged comprises a matching catch (13) which interacts with the catch (6) in the closed position thereof in order to secure the module (5) in the module receiving frame (1).

14. Receiver or interchangeable test adapter for a mass interconnect, wherein the receiver or the interchangeable test adapter comprises a module receiving frame (1) according to claim 10 or a system according to claim 12 or 13.

## Revendications

1. Mécanisme (4) destiné à fixer un module (5) inséré dans un cadre de réception du module (1) au cadre de réception du module (1) et à débloquer le module (5) pour le sortir du cadre de réception du module (1), présentant un crochet (6) disposé sur le module (5) ou le cadre de réception du module (1), lequel crochet (6) pouvant être déplacé par un mouvement de va-et-vient entre une position ouverte et une position de verrouillage du crochet (6), et un ressort (7), le mécanisme (4) présentant en outre un support du crochet (11) qui peut être déplacé par un mouvement de va-et-vient entre une position d'arrêt, dans laquelle il retient le crochet (6) contre la sollicitation du ressort (7), et une position de desserrage, dans laquelle il ne retient pas le crochet (6) contre la sollicitation du ressort (7), et étant conçu et disposé de telle manière qu'aussi bien la position d'arrêt que la position de desserrage est une position de repos du support du crochet (11), **caractérisé en ce que** le ressort (7) est prévu pour solliciter le crochet (6) dans une des deux positions, à savoir position ouverte ou position de verrouillage,
le support du crochet (11) étant conçu et disposé dans le mécanisme de telle manière qu'un mouvement du support du crochet (11) de la position d'arrêt dans la position de desserrage libère le crochet (6) de sorte que le crochet (6) se déplace par la force du ressort (7) de sa position de verrouillage dans sa position ouverte ou de sa position ouverte dans sa position de verrouillage.

2. Mécanisme (4) selon la revendication 1, **caractérisé en ce que** le ressort (7) est conçu comme plaque de ressort.

3. Mécanisme (4) selon l'une des revendications précédentes, **caractérisé en ce que** le ressort (7) et le crochet (6) sont réalisés en une seule pièce.

4. Mécanisme (4) selon l'une des revendications précédentes, **caractérisé en ce que** le support du crochet (11) est conçu de manière pivotante.

5. Mécanisme (4) selon la revendication 4, **caractérisé en ce que** le support du crochet (11) présente un excentrique.

6. Mécanisme (4) selon l'une des revendications précédentes, **caractérisé en ce que** le mécanisme (4) présente une ou plusieurs butées destinées à limiter le mouvement du support du crochet (11).

7. Mécanisme (4) selon l'une des revendications précédentes, **caractérisé en ce que** le mécanisme (4) présente des moyens d'encliquetage pour un enclenchement déblocable du support du crochet (11) dans une ou plusieurs positions encliquetées.

8. Mécanisme (4) selon l'une des revendications précédentes, **caractérisé en ce que** le ressort (7) sollicite le crochet (6) dans la position ouverte.

9. Cadre de réception du module (1) avec le mécanisme (4) selon l'une des revendications précédentes.

10. Cadre de réception du module (1) selon la revendication 9, **caractérisé en ce qu'**il comprend deux ou plusieurs mécanismes selon l'une des revendications 1 à 8.

11. Module (5) avec le mécanisme (4) selon l'une des revendications 1 à 8.

12. Système constitué d'un mécanisme (4) selon l'une des revendications 1 à 8, d'un module (5) et d'un cadre de réception du module (1).

13. Système selon la revendication 12, **caractérisé en ce que** la composante des deux composantes module (5) et le cadre de réception du module (1), sur laquelle le crochet (6) du mécanisme (4) n'est pas disposée, présente un contre-crochet (13) qui interagit avec le crochet (6) dans sa position de fermeture pour fixer le module (5) dans le cadre de réception du module (1).

14. Récepteur ou adaptateur de test interchangeable pour une interconnexion de masse, le récepteur ou l'adaptateur de test interchangeable présentant un cadre de réception du module (1) selon la revendication 10 ou un système selon la revendication 12 ou 13.
